# EUROPÄISCHE PATENTANMELDUNG

(11) **EP 1 054 436 A2**
(43) Veröffentlichungstag der Anmeldung: **22.11.2000**
(21) Anmeldenummer: 00105439.4
(22) Anmeldetag: 15.03.2000
(51) Int. Cl.: H01L 21/00

(54) **Vorrichtung zum einseitigen Ätzen einer Halbleiterscheibe**

(30) Priorität: 15.05.1999 DE 19922498
(71) Anmelder: Moritz, Hans, 34253 Lohfelden (DE)
(72) Erfinder: Moritz, Hans, 34253 Lohfelden (DE)
(74) Vertreter: Masch, Karl Gerhard, Dr.

(57) **Zusammenfassung**

Eine Vorrichtung zum einseitigen Ätzen einer Halbleiterscheibe (1) bzw. eines Wafers nach Art einer Ätzdose, bestehend aus einem plattenförmigen Grundkörper (2) mit einer Zentralöffnung (4), die kleiner als die Halbleiterscheibe (1) ist, und aus einem die Zentralöffnung (4) auf einer Seite des Grundkörpers (2) verschließenden, lösbar am Grundkörper (2) gehaltenen Deckel (3). Dabei ist die Halbleiterscheibe (1) mit Hilfe einer Dichtungsanordnung (5) aus zwei mit Abstand voneinander konzentrisch um die Zentralöffnung (4) herum angeordneten elastischen Dichtungen (6, 7), zwischen denen eine Unterdruckleitung (8) mündet, am Grundkörper (2) haltbar. Randbereich und Rückseite der Halbleiterscheibe (1) sind dem Angriff des Ätzmediums entzogen, wenn die Dichtungsanordnung (5) auf der dem Deckel (3) zugewandten Seite des Grundkörpers (2) angeordnet ist und der Deckel (3) die Dichtungsanordnung (5) sowie die an dieser gehaltene Halbleiterscheibe (1) übergreifend unter Zwischenschaltung einer weiteren Dichtungsanordnung (9) am Grundkörper (2) lösbar gehalten ist.

## Beschreibung

Die Erfindung betrifft eine Vorrichtung zum einseitigen Ätzen einer Halbleiterscheibe - auch Wafer genannt - nach Art einer Ätzdose, bestehend aus einem plattenförmigen Grundkörper mit einer Zentralöffnung, die kleiner als die Halbleiterscheibe ist, und aus einem die Zentralöffnung auf einer Seite des Grundkörpers verschließenden, lösbar am Grundkörper gehaltenen Deckel, wobei die Halbleiterscheibe mit Hilfe einer Dichtungsanordnung aus zwei mit Abstand voneinander konzentrisch um die Zentralöffnung herum angeordneten elastischen Dichtungen, zwischen denen eine Unterdruckleitung mündet, am Grundkörper haltbar ist.

Bei einer bekannten Vorrichtung der genannten Art (DE 197 28 962 A1) ist die Dichtungsanordnung auf der dem Deckel abgewandten Seite des Grundkörpers angeordnet. Dies hat zur Folge, daß die Halbleiterscheibe beim Eintauchen in das Ätzbad auch im Randbereich und auf der Rückseite neben der Dichtungsanordnung vom Ätzmittel beaufschlagt wird. Dieser Ätzmittelangriff ist unerwünscht und behindert in vielen Fällen die Weiterverarbeitung des Wafers.

Der Erfindung liegt das technische Problem zugrunde, eine Vorrichtung der eingangs genannten Art so weiter auszubilden, daß Randbereich und Rückseite der Halbleiterscheibe dem Ätzmittel sicher entzogen sind.

Zur Lösung dieser Aufgabe lehrt die vorliegende Erfindung, daß die Dichtungsanordnung auf der dem Deckel zugewandten Seite des Grundkörpers angeordnet ist und der Deckel die Dichtungsanordnung sowie die an dieser gehaltene Halbleiterscheibe übergreifend unter Zwischenschaltung einer weiteren Dichtungsanordnung am Grundkörper lösbar gehalten ist.

Der durch die Erfindung erreichte Vorteil besteht darin, daß durch eine ganz einfache konstruktive Maßnahme nur der innerhalb der Dichtungsanordnung liegende Bereich auf einer Seite der Halbleiterscheibe dem Ätzmittel ausgesetzt wird. Der Randbereich und die Rückseite der Halbleiterscheibe sind dem Ätzmittel vollkommen entzogen und können auf diese Weise keinesfalls geschädigt werden.

Für die weitere Ausgestaltung bestehen im Rahmen der Erfindung mehrere Möglichkeiten. So ist bei einer ersten bevorzugten Ausführungsform der Deckel verschwenkbar am Grundkörper gelagert. Eine andere, ebenfalls bevorzugte Ausführungsform ist dadurch gekennzeichnet, daß der Deckel mit Hilfe der weiteren Dichtungsanordnung aus zwei mit Abstand voneinander konzentrisch um die andere Dichtungsanordnung herum angeordneten elastischen Dichtungen, zwischen denen eine weitere Unterdruckleitung mündet, am Grundkörper gehalten ist. Hierdurch ist die Handhabung im Zuge der Bestückung bzw. Entnahme einer Halbleiterscheibe sehr erleichtert. Vorteilhafterweise sind die elastischen Dichtungen als Lippendichtungen ausgebildet.

Grundsätzlich besteht die Möglichkeit, den Grundkörper zusammen mit den Dichtungsanordnungen einstückig aus Kunststoff zu fertigen. Auf Dauer ist es jedoch kostengünstiger, wenn die Konstruktion so ausgeführt wird, daß die Dichtungsanordnungen austauschbar am Grundkörper gehalten sind.

Im übrigen empfiehlt es sich, daß der Deckel eine übliche Kontaktfederanordnung mit gegen die Halbleiterscheibe gehaltenen Kontaktfedern aufweist. Auch kann in den Grundkörper noch eine Ätzelektrodenanordnung integriert sein. Darüber hinaus empfiehlt es sich, den Grundkörper mit zumindest einem im Deckelraum mündenden Kanal zu versehen, um z. B. einen Druckausgleich mit der freien Atmosphäre zur Vermeidung von Beschädigungen der Halbleiterscheibe im Zuge des Ätzens durch Temperaturgradienten vornehmen zu können.

Im folgenden wird die Erfindung anhand einer ein Ausführungsbeispiel darstellenden Zeichnung näher erläutert. Es zeigen
- **Fig. 1**: eine Aufsicht auf eine Vorrichtung zum einseitigen Ätzen einer Halbleiterscheibe,
- **Fig. 2**: einen Schnitt durch den Gegenstand der Fig. 1 und
- **Fig. 3**: einen Fig. 2 entsprechenden Schnitt durch eine andere Ausführungsform.

Die in den Figuren dargestellten Vorrichtungen dienen zum einseitigen Ätzen einer Halbleiterscheibe 1, z. B. eines Silizium-Wafers, nach Art einer Ätzdose. Die Vorrichtung besteht in ihrem grundsätzlichen Aufbau zunächst aus einem plattenförmigen Grundkörper 2 und einem Deckel 3. Der Grundkörper 2 weist eine Zentralöffnung 4 auf, deren Durchmesser kleiner als der Durchmesser der Halbleiterscheibe 1 ist. Der Deckel 3 verschließt die Zentralöffnung 4 auf einer Seite des Grundkörpers 2 und ist lösbar am Grundkörper 2 gehalten. Die Halbleiterscheibe 1 ist mit Hilfe einer Dichtungsanordnung 5 am Grundkörper 2 gehalten. Diese Dichtungsanordnung 5 besteht aus zwei mit Abstand voneinander konzentrisch um die Zentralöffnung 4 herum angeordneten elastischen Dichtungen 6, 7, zwischen denen eine Unterdruckleitung 8 mündet.

Bei beiden Ausführungsformen ist die Anordnung so getroffen, daß die Dichtungsanordnung 5 auf der dem Deckel 3 zugewandten Seite des Grundkörpers 2 angeordnet ist und der Deckel 3 die Dichtungsanordnung 5 sowie die an dieser gehaltene Halbleiterscheibe 1 übergreifend unter Zwischenschaltung einer weiteren Dichtungsanordnung 9 am Grundkörper 2 lösbar gehalten ist.

Die elastischen Dichtungen 6, 7 sind in allen Fällen als Lippendichtungen ausgebildet. Der Deckel 3 weist jeweils die übliche Kontaktfederanordnung 11 mit gegen die Halbleiterscheibe 1 gehaltenen Kontaktfedern 12 auf. Im übrigen ist der Grundkörper 2 noch mit zwei Kanälen 13 versehen, die in dem zwischen Deckel 3 und Halbleiterscheibe 1 gebildeten Deckelraum 14 münden. Über diese Kanäle 13 kann ein Druckausgleich, eine Schutzgasspülung zum Abführen schädlicher Gase oder zur Trocknung und dergleichen vorgenommen werden.

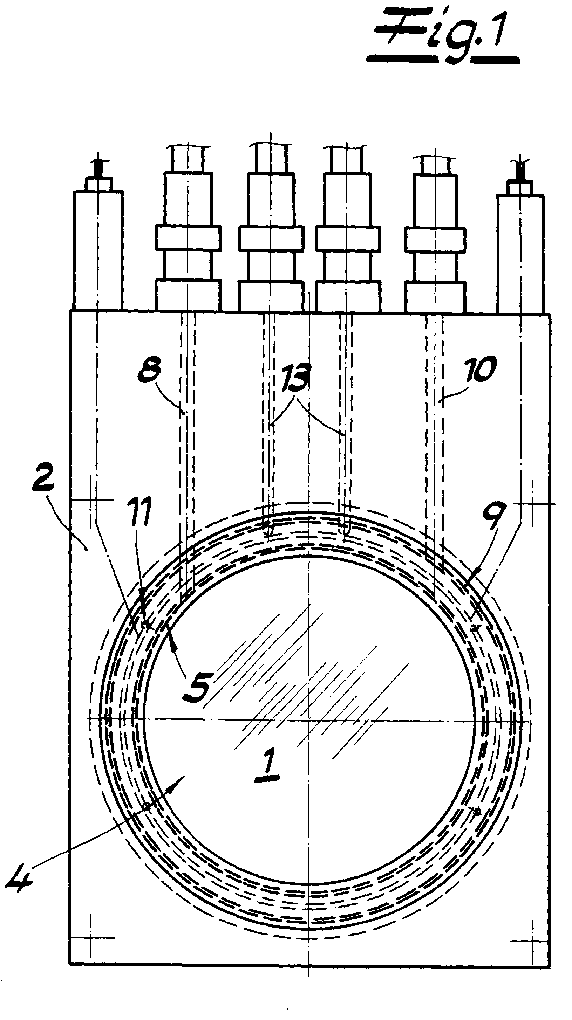

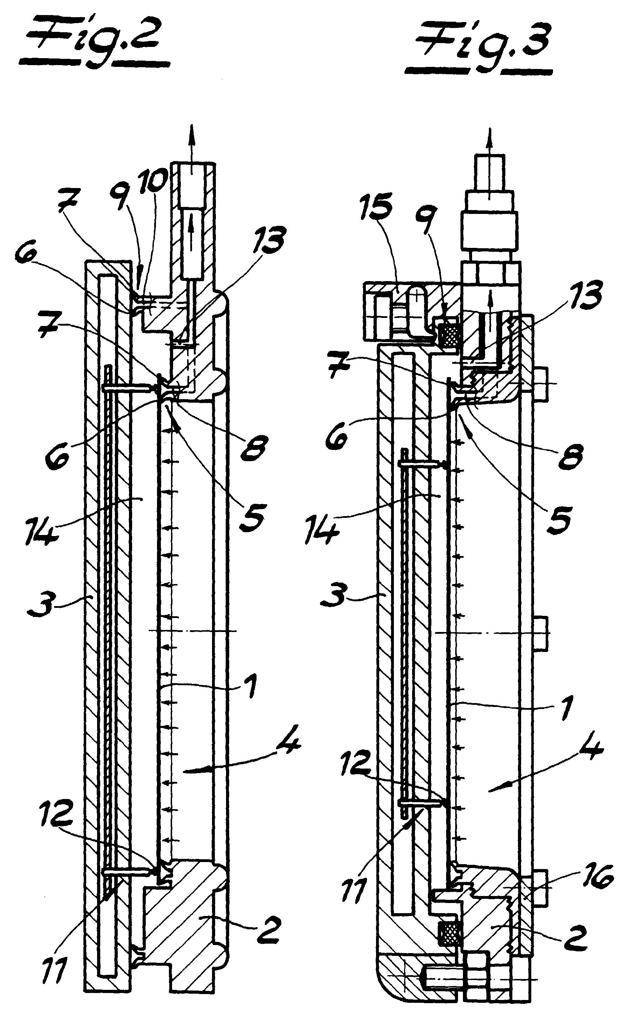

Bei der Ausführungsform nach den Fig. 1 und 2 ist der Deckel 3 mit Hilfe der weiteren Dichtungsanordnung 9, die wie die andere Dichtungsanordnung 5 aufgebaut ist, am Grundkörper 2 gehalten. Diese weitere Dichtungsanordnung 9 besteht also ebenfalls aus zwei mit Abstand voneinander konzentrisch hier um die andere Dichtungsanordnung 5 herum angeordneten Dichtungen 6, 7 in Form von Lippendichtungen, zwischen denen eine weitere Unterdruckleitung 10 mündet. Der Grundkörper 2 mit den beiden Dichtungsanordnungen 5, 9 ist einstückig in Kunststoff ausgeführt.

Bei der Ausführungsform nach Fig. 3 ist der Deckel 3 verschwenkbar am Grundkörper 2 gelagert und mit Hilfe eines Befestigungsbügels 15 gegen den Grundkörper 2 preßbar, wobei ein am Rand eingelegter elastischer Dichtungsring als weitere Dichtungsanordnung 9 zusammengepreßt wird. Im übrigen erkennt man, daß Grundkörper 2 und Dichtungsanordnung 5 hier aus unterschiedlichen Werkstoffen gefertigt sind. Die Dichtungsanordnung 5 ist mit Hilfe eines Schraubklemmringes 16 austauschbar am Grundkörper 2 gehalten.

## Patentansprüche

1. Vorrichtung zum einseitigen Ätzen einer Halbleiterscheibe nach Art einer Ätzdose, bestehend aus einem plattenförmigen Grundkörper mit einer Zentralöffnung, die kleiner als die Halbleiterscheibe ist, und aus einem die Zentralöffnung auf einer Seite des Grundkörpers verschließenden, lösbar am Grundkörper gehaltenen Deckel, wobei die Halbleiterscheibe mit Hilfe einer Dichtungsanordnung aus zwei mit Abstand voneinander konzentrisch um die Zentralöffnung herum angeordneten elastischen Dichtungen, zwischen denen eine Unterdruckleitung mündet, am Grundkörper haltbar ist, **dadurch gekennzeichnet**, daß die Dichtungsanordnung (5) auf der dem Deckel (3) zugewandten Seite des Grundkörpers (2) angeordnet ist und der Deckel (3) die Dichtungsanordnung (5) sowie die an dieser gehaltene Halbleiterscheibe (1) übergreifend unter Zwischenschaltung einer weiteren Dichtungsanordnung (9) am Grundkörper lösbar gehalten ist.

2. Vorrichtung nach Anspruch 1, dadurch gekennzeichnet, daß der Deckel (3) verschwenkbar am Grundkörper (2) gelagert ist.

3. Vorrichtung nach Anspruch 1, dadurch gekennzeichnet, daß der Deckel (3) mit Hilfe der weiteren Dichtungsanordnung (9) aus zwei mit Abstand voneinander konzentrisch um die andere Dichtungsanordnung (5) herum angeordneten elastischen Dichtungen (6, 7), zwischen denen eine weitere Unterdruckleitung (10) mündet, am Grundkörper (2) gehalten ist.

4. Vorrichtung nach einem der Ansprüche 1 bis 3, dadurch gekennzeichnet, daß die elastischen Dichtungen (6, 7) als Lippendichtungen ausgebildet sind.

5. Vorrichtung nach einem der Ansprüche 1 bis 4, dadurch gekennzeichnet, daß die Dichtungsanordnungen (5, 9) austauschbar am Grundkörper (2) gehalten sind.

6. Vorrichtung nach einem der Ansprüche 1 bis 4, dadurch gekennzeichnet, daß der Deckel (3) eine Kontaktfederanordnung (11) mit gegen die Halbleiterscheibe (1) gehaltenen Kontaktfedern (12) aufweist.

7. Vorrichtung nach einem der Ansprüche 1 bis 6, dadurch gekennzeichnet, daß der Grundkörper (2) zumindest einen im Deckelraum (14) mündenden Kanal (13) aufweist.
